# EUROPÄISCHE PATENTSCHRIFT

(11) **EP 0 553 472 B1**
(45) Veröffentlichungstag und Bekanntmachung des Hinweises auf die Patenterteilung: **19.11.1997**
(21) Anmeldenummer: 92121529.9
(22) Anmeldetag: 18.12.1992
(51) Int. Cl.: G01R 31/00, G06F 11/26

(54) **Verfahren und Vorrichtung zum Prüfen einer Einrichtung, die wenigstens einen Mikrorechner enthält**
Process and appliance for testing an apparatus which comprises at least one microprocessor
Procédé et dispositif pour tester un appareil comprenant au moins un microprocesseur

(30) Priorität: 31.01.1992 DE 4202726
(43) Veröffentlichungstag der Anmeldung: 04.08.1993
(73) Patentinhaber: ROBERT BOSCH GMBH, 70442 Stuttgart (DE)
(72) Erfinder: Locher, Johannes, Ing. (grad.), W-7000 Stuttgart 50 (DE); Fischer, Werner, Dipl.-Ing., W-7258 Heimsheim (DE); Schönfelder, Dietbert, Dipl.-Ing., W-7000 Stuttgart 1 (DE); Schmitz, Peter, Dr., W-7140 Ludwigsburg-Ossweil 1 (DE)

(56) Entgegenhaltungen:
- DE-A- 4 028 504
- US-A- 4 816 656

## Beschreibung

### Stand der Technik

Die Erfindung betrifft eine Vorrichtung und ein Verfahren zum Prüfen einer Einrichtung zur Steuerung einer wenigstens einen Mikrorechner enthaltenden Brennkraftmaschine, insbesondere einer Dieselbrennkraftmaschine.

Ein Verfahren und eine Vorrichtung gemäß den Oberbegriffen der unabhängigen Ansprüche ist aus der DE-OS 40 28 504 bekannt. Dort wird ein Verfahren, eine Vorrichtung zum Prüfen einer Einrichtung zur Steuerung einer Brennkraftmaschine, die wenigstens einen Mikrorechner enthält, beschrieben. Eine Bewertungsschaltung überprüft, ob ein Element der Vorrichtung ein bestimmtes Potential aufweist. Nimmt das Potential einen ersten Wert an, so geht die Einrichtung unmittelbar in einen Betriebsmodus über. Liegt ein zweiter Wert an, so geht die Einrichtung unmittelbar in einen Prüfmodus über.

Aus der Druckschrift US-A-48 16 656 ist ein IC Kartensystem bekannt, bei dem die Zugriffsberechtigung Stufenweise überprüft wird.

Problematisch bei dieser Einrichtung ist es, daß der Prüfmodus auch in Fällen erreicht wird, wenn eigentlich der normale Betriebsmodus gewählt werden soll. Dies kann unter Umständen zu wesentlichen Beeinträchtigungen der Fahrsicherheit führen.

Üblicherweise wird bei der Prüfung von Einrichtungen, die einen Mikrorechner enthalten, so vorgegangen, daß der Prüfmodus, in dem die Einrichtung auf ihre korrekte Funktion überprüft wird, nur nach Durchlaufen verschiedener Abfrageeinheiten erreichbar ist. Mittels dieser Abfragen soll verhindert werden, daß der Prüfmodus im normalen Betriebsmodus erreicht werden kann, da dies unter Umständen zu einer wesentlichen Beeinträchtigung der Fahrsicherheit führen kann. Eine solche Vorgehensweise hat den Nachteil, daß bei den sich an die Fertigung anschließenden Testläufen der Prüfmodus erst nach einer sehr langen Wartezeit erreicht werden kann. Dies führt unter Umständen zu erheblichen Zeitverlusten und damit zu erhöhten Fertigungskosten.

### Aufgabe der Erfindung

Der Erfindung liegt daher die Aufgabe zugrunde, ein Verfahren und eine Vorrichtung zum Prüfen einer Einrichtung, die wenigstens ein Mikrorechner enhält, zu schaffen, bei denen das ungewollte Erreichen eines Prüfmodus sicher verhindert wird, andererseits dagegen die Prüfzeiten bei der Fertigung entscheidend verkürzt werden können. Bei der Prüfung des Steuergeräts im Werk vor Auslieferung soll der Prüfmodus sehr einfach und schnell erreichbar sein. Andererseits soll bei einem ausgelieferten Steuergerät verhindert werden, daß der Prüfmodus zufällig oder durch Unbefugte ansprechbar ist.

### Vorteile der Erfindung

Diese Aufgabe wird durch die Merkmale der unabhängigen Ansprüche 1 und 5 gelöst.

Mit dieser Vorgehensweise läßt sich der Zeitaufwand für die werkseitige Prüfung erheblich verringern, ohne daß dadurch die Gefahr erhöht wird, daß der Prüfmodus zufällig oder durch Unbefugte angesprochen werden kann.

Vorteilhafte und zweckmäßige Ausgestaltungen und Weiterbildungen der Erfindung sind in den Unteransprüchen gekennzeichnet.

### Zeichnung

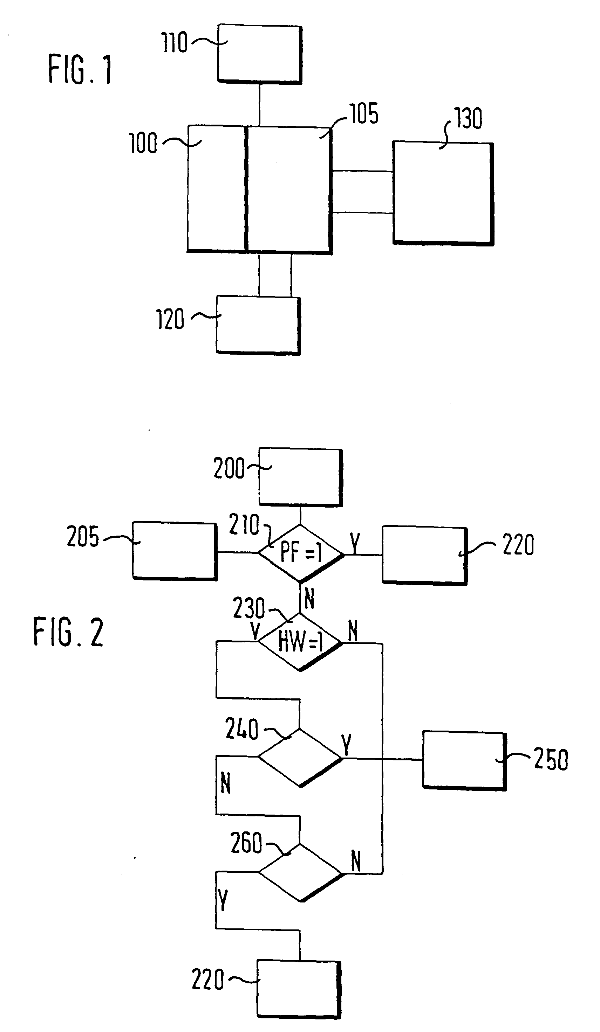

Die Erfindung wird nachstehend anhand der in der Zeichnung dargestellten Ausführungsform erläutert. Die Figur 1 zeigt grobschematisch ein Blockdiagramm der erfindungsgemäßen Einrichtung, und die Figur 2 ein Flußdiagramm zur Verdeutlichung der Funktionsweise des Verfahrens.

### Beschreibung des Ausführungsbeispiels

In Figur 1 ist die erfindungsgemäße Einrichtung grobschematisch dargestellt. Eine Einrichtung 100 erhält Signale von verschiedenen Sensoren 110. Des weiteren tauscht sie Daten mit einem Steller 120 aus. Die Einrichtung 100 enthält zumindestens einen Mikrorechner 105. Um die Einrichtung einschließlich des Mikrorechners auf Funktionsfähigkeit zu überprüfen, ist vorgesehen, daß die Einrichtung 100 mit einer Prüfeinrichtung 130 verbunden werden kann. Diese Prüfeinrichtung 130 kann aber auch in die Einrichtung 100 integriert sein.

Ist die Prüfeinrichtung 130 ein Teil der Einrichtung 100, so ist es besonders wichtig, daß der Prüfmodus nicht unbeabsichtigt erreicht wird.

Diese Einrichtung wird vorzugsweise zur Steuerung von Brennkraftmaschinen, insbesondere von Dieselbrennkraftmaschinen eingesetzt. In diesem Fall handelt es sich bei dem Steller vorzugsweise um ein leistungsbestimmendes Stellglied. Als leistungsbestimmendes Stellglied 120 kann ein Magnetventil, das zur Festlegung der eingespritzten Kraftstoffmenge und des genauen Einspritzzeitpunkts dient, eingesetzt werden. Es ist aber auch denkbar, daß ein Elektromagnet oder ein Elektromotor, der eine Drosselklappe oder eine Regelstange in eine vorgegebene Stellung bringt, als leistungsbestimmendes Stellglied dient.

Bei der Arbeitsweise dieser Einrichtung sind zwei verschiedene Betriebszustände zu unterscheiden. Im Normalbetrieb, der auch als Betriebsmodus bezeichnet wird, berechnet die Einrichtung 100 ausgehend von den von den Sensoren 110 abgegebenen Sensorsignalen Ansteuersignale zur Beaufschlagung des Stellers 120. Die hierzu notwendigen Berechnungen erfolgen vorzugsweise in dem Mikrorechner 105.

Des weiteren ist ein Prüfmodus vorgesehen. Bei der Produktion dieser Einrichtung ist die Wahrscheinlichkeit groß, daß fehlerhafte Bauteile verwendet werden. Daher sind vor der Auslieferung der Einrichtung umfangreiche Prüfungen erforderlich. Solche Prüfungen werden zum einen durchgeführt, bevor die Einrichtung mit der zu steuernden Brennkraftmaschine verbunden wird. Prüfungen finden aber auch später, zum Beispiel im Rahmen der Wartung statt. Zur Durchführung dieser Prüfungen wird die Einrichtung 100 mit der Püfeinrichtung 130 verbunden und in den Prüfmodus übergegangen.

Die Prüfeinrichtung 130 arbeitet dann ein Testprogramm ab. Dieses dient dazu die ordnungsgemäße Funktionsweise der Einrichtung 100 einschließlich des Mikrorechners 105 zu überprüfen.

Es ist nun wünschenswert, daß vor der Auslieferung bei der Fertigung der Prüfmodus sehr schnell erreicht werden kann. Andererseits darf aber im Normalbetrieb keineswegs der Fall eintreten, daß der Prüfmodus unbeabsichtigt oder von unberechtigten Personen eingeleitet wird. Bisher ist vorgesehen, daß zuerst verschiedene Bedingungen dahingehend abgefragt werden, ob in den Betriebsmodus oder in den Prüfmodus überzugehen ist. Diese Abfragen erfordern sehr viel Zeit.

Auf diese Abfrage kann aber auch nicht verzichtet werden, da andernfalls der Prüfmodus bei Vorliegen von Fehlern ungewollt oder von nicht berechtigten Personen ansprechbar ist. Es wird daher vorgeschlagen, daß in einem Speicherelement, das auch als Prüfflag bezeichnet wird, ein bestimmter Wert abgelgt wird. Bei Inbetriebnahme der Einrichtung wird als erstes dieser Prüfflag abgefragt. Enthält dieser den vorgegebenen Wert, so wird sofort in den Prüfmodus übergegangen. Sind die Prüfarbeiten und Einstellarbeiten abgeschlossen, so wird dieser Prüfflag zurückgesetzt. Dies bewirkt, daß beim nächsten Einschalten die üblichen Abfragen zur Überprüfung, ob der Prüfmodus eingeleitet werden kann, durchlaufen werden müssen.

Durch diese erfindungsgemäße Vorgehensweise kann erreicht werden, daß einerseits während der werkseitigen Prüfungen der Prüfmodus relativ schnell erreichbar ist und andererseits nach Auslieferung der Einrichtung ein ungewolltes oder unberechtigtes Aufrufen des Prüfmodus weitestgehend verhindert werden kann.

In Figur 2 ist die erfindungsgemäße Vorgehensweise anhand eines Flußdiagramms dargestellt. Nach Erkennen eines Resets im Schritt 200, der zum Beispiel durch Einschalten der Einrichtung ausgelöst wird, folgt eine erste Abfrage 210, die einen Prüfflag 205 dahingehend abfragt, ob es den Wert 1 annimmt. Ist dies der Fall, so wird das Programm unmittelbar im Schritt 220 mit dem Prüfmodus fortgesetzt.

Nimmt der Prüfflag den Wert Null an, so folgt eine zweite Abfrage 230. Diese zweite Abfrage 230 überprüft, ob eine Hardware-Bedingung erfüllt ist. Erkennt diese, daß eine bestimmte Hardware-Bedingung nicht vorliegt, so wird im Schritt 250 unmittelbar in den Betriebsmodus übergegangen. Eine solche Hardware-Abfrage kann zum Beispiel derart gestaltet sein, daß die Abfrage 230 überprüft, ob die Prüfeinrichtung 130 angeschlossen ist.

Eine weitere Ausgestaltung der Abfrage 230 sieht vor, daß die Abfrage 230 überprüft, ob kein Steller angeschlossen ist. Eine solche Abfrage erfolgt vorzugsweise dadurch, daß überprüft wird, ob der Steller Ansteuersignale mit entsprechenden Rückmeldesignalen beantwortet, oder dadurch, welchen Zustand die Ausgangsleitung zum Steller besitzt.

In der dritten Abfrage 240 wird überprüft, ob ein Signalaustausch mit externen Bauteilen, wie zum Beispiel den Sensoren 110 oder dem Steller 120 möglich ist. Ist dies der Fall, so wird sofort in den Betriebsmodus übergegangen. Die vierte Abfrage 260 überprüft, ob das richtige Paßwort eingegeben wurde. Ist dies der Fall, so wird in den Prüfmodus 220 übergegangen. Andernfalls geht das Programm in den Betriebsmodus über.

Ist der Prüfflag 205 mit dem Wert 1 belegt, so zeigt dies an, daß direkt in den Prüfmodus überzugehen ist. Ist es andererseits mit dem Wert 0 belegt, so zeigt dies an, daß erst nach weiteren Abfragen auf den Prüfmodus übergegangen werden kann. Nach Abschluß aller werkseitigen Prüfungen wird der Wert des Prüfflags von 1 auf 0 zurückgesetzt. Natürlich kann auch in umgekehrter Weise vorgegangen werden. So kann auch der Wert 0 anzeigen, daß direkt in den Prüfmodus übergegangen wird.

Anstelle des Prüfflags kann auch der Signalpegel an einer vorgebenen Stelle innerhalb der Einrichtung auf einen vorgegebenen Wert abgefragt werden. So ist es zum Beispiel möglich, die vorgegebene Stelle direkt mit Batteriepotential zu verbinden. Alternativ kann auch vorgesehen werden, die vorgegebene Stelle auf einen bestimmten Spannungswert zu legen. In diesem Fall überprüft die Abfrage, ob die vorgegebene Stelle auf Batteriespannung bzw. auf dem bestimmten Spannungswert liegt.

Nach Beendigung der Prüfarbeiten wird dieser Eingang dann von der Batteriespannung bzw dem definierten Spannungspegel getrennt. Dies kann beispielsweise durch Unterbrechen der Leiterbahn, die die Abfrageeinheit mit der Batteriespannung verbindet, erfolgen. Entsprechendes kann auch durch Ausbau oder Einbau eines Bauteils erzielt werden. So läßt sich der Widerstandswert am Eingang der Abfrage 210 gezielt durch Aus- oder Einbau eines Bauteils, wie zum Beispiel eines Widerstands, verändern.

## Patentansprüche

1. Vorrichtung zum Prüfen einer Einrichtung (100) zur Steuerung einer Brennkraftmaschine, insbesondere einer Dieselbrennkraftmaschine, wobei die Vorrichtung wenigstens einen Mikrorechner (105) enthält, wobei Abfragemittel (210) vorgesehen sind, die einen Prüfflag, einen Signalpegel oder ein Speicherelement auf das Vorliegen eines ersten Wertes abfragen, wobei Mittel vorgesehen sind, die bei Vorliegen des ersten Wertes veranlassen, daß die Einrichtung direkt in einen Prüfmodus übergeht, in dem die Einrichtung geprüft wird, dadurch gekennzeichnet, daß die Mittel bei Vorliegen eines zweiten Wertes bewirken, daß weitere Abfragemittel aktiviert werden, die entscheiden, ob in den Prüfmodus oder in einen Betriebsmodus, in dem die Einrichtung die Brennkraftmaschine steuert, übergegangen wird.

2. Vorrichtung nach Anspruch 1, dadurch gekennzeichnet, daß die Abfragemittel den Inhalt des Prüfflags abfragen.

3. Vorrichtung nach Anspruch 1, dadurch gekennzeichnet, daß es sich bei dem Signalpegel um einen bestimmten Signalpegel an einer vorgegebenen Stelle der Einrichtung handelt.

4. Vorrichtung nach Anspruch 1 oder 3, dadurch gekennzeichnet, daß der Signalpegel durch Unterbrechen einer Leiterbahn, den Ausbau oder den Einbau eines Elements veränderbar ist.

5. Verfahren zum Prüfen einer Einrichtung (100) zur Steuerung einer Brennkraftmaschine, insbesondere einer Dieselbrennkraftmaschine, wobei die Einrichtung wenigstens einen Mikrorechner (105) enthält, wobei erste Abfragemittel einen Prüfflag, einen Signalpegel oder ein Speicherelement auf das Vorliegen eines ersten Wertes abfragen, wobei bei Vorliegen des ersten Wertes die Einrichtung direkt in einen Prüfmodus, in dem die Einrichtung geprüft wird, übergeht, dadurch gekennzeichnet, daß bei Vorliegen eines zweiten Wertes, der nach Abschluß aller werksseitigen Prüfungenanstelle des ersten Wertes gesetzt wird, weitere Abfragemittel aktiviert werden, die entscheiden, ob in den Prüfmodus oder in einen Betriebsmodus, in dem die Einrichtung die Brennkraftmaschine steuert, übergegangen wird.

6. Verfahren nach Anspruch 5, dadurch gekennzeichnet, daß eines der weiteren Abfragemittel erkennt, ob ein Steller (120) angeschlossen ist, und in diesem Fall den Betriebsmodus aktiviert.

7. Verfahren nach Anspruch 6, dadurch gekennzeichnet, daß eines der weiteren Abfragemittel erkennt, ob ein Signalaustausch mit dem Steller (120) stattfindet, und in diesem Fall den Betriebsmodus aktiviert.

8. Verfahren nach einem der vorstehenden Ansprüche 5 bis 7, dadurch gekennzeichnet, daß eines der weiteren Abfragemittel überprüft, ob eine gültige Paßworteingabe vorliegt, und in diesem Fall den Prüfmodus aktiviert.

## Claims

1. Appliance for testing an apparatus (100) for controlling an internal combustion engine, in particular a diesel internal combustion engine, the appliance containing at least one microcomputer (105), interrogation means (210) being provided which interrogate a check flag, a signal level or a memory element for the presence of a first value, means being provided which, in the presence of a first value, cause the apparatus to go directly into a test mode in which the apparatus is tested, characterized in that, in the presence of a second value, the means cause further interrogation means to be activated, which further interrogation means decide whether the apparatus goes into the test mode or into an operating mode in which the apparatus controls the internal combustion engine.

2. Appliance according to Claim 1, characterized in that the interrogation means interrogate the contents of the check flag.

3. Appliance according to Claim 1, characterized in that the signal level is a specific signal level at a prescribed point of the apparatus.

4. Appliance according to Claim 1 or 3, characterized in that the signal level can be varied by interrupting a conductor track, or by the removal or installation of an element.

5. Method for testing an apparatus (100) for controlling an internal combustion engine, in particular a diesel internal combustion engine, the apparatus containing at least one microcomputer (105), first interrogation means interrogating a check flag, a signal level or a memory element for the presence of a first value, in which case, in the presence of the first value, the apparatus goes directly into a test mode in which the apparatus is tested, characterized in that in the presence of a second value which has been set instead of the first value after all the works-side tests have been completed, further interrogation means are activated which decide whether the apparatus goes into the test mode or into an operating mode in which the apparatus controls the internal combustion engine.

6. Method according to Claim 5, characterized in that one of the further interrogation means detects whether an actuator (120) is connected and, if this is the case, activates the operating mode.

7. Method according to Claim 6, characterized in that one of the further interrogation means detects whether signals are being exchanged with the actuator (120) and, if this is the case, activates the operating mode.

8. Method according to one of the preceding Claims 5 to 7, characterized in that one of the further interrogation means checks whether a valid password entry has been made and, if this is the case, activates the test mode.

## Revendications

1. Dispositif pour contrôler une installation (100) servant à commander un moteur à combustion interne, notamment un moteur diesel,
• le dispositif comportant au moins un microprocesseur (105),
• des moyens d'interrogation (210) étant prévus pour interroger un drapeau de contrôle, un niveau de signal ou un élément de mémoire, et pour vérifier l'existence d'une première valeur,
• des moyens étant prévus qui, en présence de la première valeur, font que l'installation passe directement en mode de contrôle consistant à vérifier l'installation,
caractérisé en ce que
en présence d'une seconde valeur, les moyens activent d'autres moyens d'interrogation qui décident s'il faut passer en mode de contrôle ou en mode de fonctionnement pour lequel l'installation commande le moteur à combustion interne.

2. Dispositif selon la revendication 1,
caractérisé en ce que
les moyens d'interrogation demandent le contenu du drapeau de contrôle.

3. Dispositif selon la revendication 1,
caractérisé en ce que
le niveau du signal est un niveau de signal défini à un endroit prédéterminé de l'installation.

4. Dispositif selon la revendication 1 ou 3,
caractérisé en ce que
le niveau du signal peut être modifié par l'interruption d'un chemin conducteur, par le démontage ou par l'adjonction d'un élément.

5. Procédé de contrôle d'une installation (100) commandant un moteur à combustion interne, notamment un moteur diesel,
• l'installation étant équipée d'au moins un microprocesseur (105), des premiers moyens d'interrogation demandant un drapeau de contrôle, un niveau de signal ou un élément de mémoire, pour vérifier la présence d'une première valeur,
• et en présence de la première valeur, l'installation passe directement en mode de contrôle consistant à vérifier l'installation,
caractérisé en ce que
en présence d'une seconde valeur qui, à la fin des contrôles faits en usine, remplace la première valeur, on active d'autres moyens d'interrogation qui décident s'il faut passer en mode de contrôle ou en mode de fonctionnement par lequel l'installation commande le moteur à combustion interne.

6. Procédé selon la revendication 5,
caractérisé en ce que
l'un des autres moyens d'interrogation reconnaît qu'un actuateur (120) est branché et, dans ce cas, il active le mode de fonctionnement.

7. Procédé selon la revendication 6,
caractérisé en ce que
l'un des autres moyens d'interrogation reconnaît qu'un échange de signaux se produit avec l'actuateur (120) et, dans ce cas, il active le mode de fonctionnement.

8. Procédé selon l'une des revendications précédentes 5 à 7,
caractérisé en ce que
l'un des autres moyens d'interrogation vérifie la présence de l'entrée validée d'un mot de code et, dans ce cas, il active le mode de contrôle.
